# FASCICULE DE BREVET EUROPEEN

(11) **EP 0 495 065 B1**
(45) Date de publication et mention de la délivrance du brevet: **06.11.1996**
(21) Numéro de dépôt: 91914684.5
(22) Date de dépôt: 31.07.1991
(51) Int. Cl.: C23C 16/18, C23C 16/40, C23C 16/56

(54) **PROCEDE POUR DEPOSER UN FILM MINCE TRANSPARENT ET ANTISTATIQUE A LA SURFACE D'UN OBJET FA ONNE, DONT AU MOINS LA PARTIE SUPERFICIELLE EST EN UN POLYMERE OU COPOLYMERE DE STYRENE, ET CONFERER AINSI AUDIT OBJET UN ANTISTATISME DURABLE SANS MODIFIER SON ASPECT DE SURFACE**
VERFAHREN ZUR BESCHICHTUNG DER OBERFLÄCHE EINES GEFORMTEN OBJEKTES MIT EINEM TRANSPARENTEN ANTISTATISCHEN DÜNNEN FILM, WELCHES ZUMINDEST AN DER OBERFLÄCHE AUS STYROLPOLYMER ODER COPOLYMER BESTEHT, UM DAS GENANNTE OBJEKT MIT BLEIBENDEN ANTISTATISCHEN EIGENSCHAFTEN ZU VERSEHEN, OHNE SEIN ÄUSSERES ZU VERÄNDERN
METHOD FOR DEPOSITING A TRANSPARENT ANTISTATIC THIN FILM ON THE SURFACE OF A SHAPED OBJECT OF WHICH AT LEAST THE SURFACE PORTION IS MADE OF A STYRENE POLYMER OR COPOLYMER, TO PROVIDE SAID OBJECT WITH LASTING ANTISTATIC PROPERTIES WITHOUT ALTERING ITS APPEARANCE

(30) Priorité: 01.08.1990 FR 9009839
(43) Date de publication de la demande: 22.07.1992
(73) Titulaire: ELF AQUITAINE, 92400 Courbevoie (FR)
(72) Inventeur: VERZARO, Francis, F-64121 Serres-Castet (FR); SEGUI, Yvan, Mons F-31130 Balma (FR)
(74) Mandataire: Boillot, Marc
(86) Numéro de dépôt international: FR9100631
(87) Numéro de publication internationale: WO9202661

(56) Documents cités:
- EP-A- 0 291 444
- EP-A- 0 371 582
- US-A- 4 140 814
- US-A- 4 618 507
- US-A- 4 865 883
- THIN SOLID FILMS, vol. 97, no. 1, novembre 1982, Lausanne (CH); R.K. SADHIR et al., pp. 17-29, "Preparation of metallic organotin films by glow discharge polymerization and their properties"

## Description

L'invention se rapporte à un procédé pour déposer un film mince transparent et antistatique à la surface d'un objet façonné, dont au moins la partie superficielle est en un polymère ou copolymère de styrène, et conférer ainsi audit objet un antistatisme durable sans modifier son aspect de surface.

Le polystyrène, modifié ou non par un élastomère comme le polybutadiène, se transforme facilement par moulage par injection ou par extrusion et thermoformage en objets façonnés qui trouvent un débouché dans le domaine du conditionnement et dans celui des biens d'équipement. Le polystyrène standard, encore appelé "polystyrène cristal" est destiné aux applications pour lesquelles un produit rigide et transparent est recherché, par exemple luminaires, gobelets, boîtes de rangement. Le polystyrène modifié par un élastomère tel que le polybutadiène s'adresse aux applications pour lesquelles une résistance élevée au choc est requise, par exemple chassis de radios ou de téléviseurs, pièces de réfrigérateurs, éléments pour sanitaires, meubles, emballages laitiers.

Le polystyrène étant un isolant électrique, comme la quasi-totalité des matières plastiques, les objets façonnés en polystyrène accumulent en surface les charges électrostatiques avec comme inconvénients d'une part l'attraction des poussières par la surface chargée électrostatiquement et d'autre part la production de décharges électrostatiques au toucher de l'objet pendant sa manutention ou son utilisation.

Actuellement, la solution la plus courante pour éliminer l'électricité statique portée par les objets façonnés à partir d'une matière plastique et notamment à partir d'un polystyrène, consiste à incorporer à ladite matière plastique, avant son façonnage, un additif, dit additif antistatique, choisi parmi les composés chimiques, par exemple dérivés d'ammonium quaternaire ou encore amines éthoxylées, qui comportent une partie polaire et d'autre part sont susceptibles de migrer à la surface de l'objet façonné, ce qui permet d'augmenter la conductivité de surface dudit objet et ce faisant de réduire la tendance de l'objet façonné à accumuler les charges électrostatiques en surface.

Une telle façon de procéder présente certains inconvénients majeurs. Tout d'abord, l'effet antistatique n'a qu'une durée limitée dans le temps, environ 1 à 2 mois, et dans tous les cas on observe une décroissance dudit effet au cours du temps. Ce phénomène peut être expliqué par le fait que les additifs antistatiques ne sont pas liés à la matrice polymérique avec comme conséquence qu'un simple lavage de la surface de l'objet façonné peut éliminer lesdits additifs. En outre, l'effet antistatique est mal contrôlé. Après disparition de cet effet, il peut apparaître au cours du temps une deuxième vague de diffusion de l'additif antistatique vers la surface de l'objet et l'effet antistatique peut réapparaître lorsque cette vague atteint ladite surface. Toutefois, durant ce temps, l'objet a été privé de toute propriété antistatique. De plus, l'effet antistatique dépend du degré d'humidité de l'air ambiant et, en atmosphère sèche, on observe une diminution sensible dudit effet.

Dans la recherche de solutions permettant d'éliminer l'électricité statique portée par un objet façonné en un polymère ou copolymère de styrène autrement qu'en incorporant un additif antistatique au polymère ou copolymère avant son façonnage, on a trouvé qu'en utilisant la technologie du plasma froid dans des conditions spécifiques, on pouvait, à partir d'un précurseur consistant en vapeurs d'un composé organoétain, déposer un film mince antistatique et transparent à la surface de l'objet façonné et par la même conférer audit objet ainsi revêtu un antistatisme durable, par suite des excellentes propriétés antistatiques du film déposé et de son adhérence satisfaisante à l'objet façonné, sans modifier l'aspect de surface de cet objet, du fait de la transparence dudit film.

On sait (US-A-4865883) que l'on peut déposer un film conducteur transparent renfermant de l'indium ou de l'étain sur un substrat, par exemple substrat métallique, verre, céramique, substrat en un matériau polymère tel que polyester, polyethylène, PVC, polystyrène ou polyamide, en faisant appel à une méthode de dépôt par réaction chimique en phase vapeur utilisant un mélange gazeux précurseur renfermant des composés organoindium ou organoétain, un halogène, par exemple chlore ou de préférence fluor, à l'état gazeux ou à l'état naissant et un gaz renfermant de l'oxygène, par exemple O₂, NO, N₂O, CO, CO₂ ou H₂O et en opérant en l'absence de toute décharge électrique pour exciter le mélange gazeux précurseur du film.

On sait encore (US-A-4140814) que l'on peut réaliser un dépôt transparent et conducteur en oxyde d'étain sur un substrat, en exposant le substrat, maintenu de préférence entre 200°C et 500°C, à l'action d'un mélange de CO₂ et d'un composé organique de l'étain, en opérant sous pression réduite dans une décharge radiofréquence avec une densité de puissance de 1 à 3 mW et de préférence d'environ 1,3 à 1,7 mW par cm³. Le rapport molaire CO₂ : composé organique de l'étain, dans le mélange de ces composés est compris entre 50 : 1 et 300 : 1 et de préférence entre 100 : 1 et 250 : 1.

L'invention propose un procédé pour déposer un film mince antistatique et transparent à la surface d'un objet façonné, dont au moins la partie superficielle est en un polymère ou copolymère de styrène, et conférer ainsi audit objet un antistatisme durable sans modifier l'aspect de surface de cet objet, caractérisé en ce que l'on produit un flux gazeux réactif du type plasma froid en générant un champ électrique continu, alternatif ou pulsé ayant une fréquence allant de 0Hz à 1000 kHz, de préférence de 0Hz à 100 kHz, dans une atmosphère gazeuse maintenue sous une pression comprise entre 5 Pa et 100 Pa, plus particulièrement entre 10 et 70 Pa, et constituée de vapeurs d'une composante organoétain formée d'un ou plusieurs composés organoétains ayant un point d'ébullition inférieur à 20°C sous une pression de 150 Pa, la génération du champ électrique étant réalisée entre deux électrodes, entre lesquelles est placé l'objet façonné à traiter, et avec une densité de puissance comprise entre 50 mW et 350 mW par cm² d'électrode et l'on maintient ledit objet façonné, à une température inférieure à son point de ramollissement, de préférence entre 10°C et 60°C, au contact du flux gazeux réactif prenant naissance pendant une durée suffisante pour déposer à la surface dudit objet un film dérivant de la composante organoétain et dont l'épaisseur est comprise entre 10 nm et 1500 nm et de préférence entre 100 nm et 1000 nm.

Comme il est connu dans l'art (cf., par exemple, l'encyclopédie de KIRK-OTHMER intitulée ENCYCLOPEDIA OF CHEMICAL TECHNOLOGY, Third Edition, Supplement Volume, page 614), le terme "plasma froid" désigne un plasma gazeux hors équilibre thermodynamique pour lequel la température des électrons est très élevée par rapport à la température des autres espèces contenues dans le plasma, cette dernière température restant proche de la température ambiante.

L'atmosphère gazeuse à base de vapeurs de la composante organoétain, que l'on soumet à l'action du champ électrique pour produire le flux gazeux réactif, peut encore renfermer une composante gazeuse oxygénée consistant en un ou plusieurs gaz oxygénés, tels que oxygène, vapeur d'eau, air, en quantité représentant au plus 10 % en volume du mélange de la composante gazeuse organoétain et de la composante gazeuse oxygénée.

Après sa mise en contact avec le flux gazeux réactif produit à partir des vapeurs de la composante organoétain, l'objet façonné peut encore subir un post-traitement consistant en une mise en contact, pendant une durée pouvant aller de 0,1 s à 1000 s, avec un plasma froid généré à partir d'un gaz oxygéné, avantageusement oxygène ou/et vapeur d'eau, sous une pression allant de 1 Pa à 100 Pa et d'un champ électrique continu, alternatif ou pulsé.

Les composés organoétains à partir desquels on peut former la composante organoétain sont avantageusement choisis parmi les composés organoétains qui, d'une part, répondent à la formule générale Sn (R)ₓ (Cl)_{y}, où les R, identiques ou différents, représentent des radicaux alcoyles ou alcényles inférieurs, notamment méthyle, éthyle et vinyle, y est un nombre égal à 4-x et x est un nombre entier allant de 2 à 4, et, d'autre part, ont un point d'ébullition inférieur à 20°C sous une pression de 150 Pa. A titre d'exemples de tels composés, on peut citer notamment le tétraméthylétain, le diméthyldichloroétain, le vinyltriméthylétain, le triméthyléthylétain, le tétraéthylétain, le tétravinylétain et le diméthyldivinylétain.

Le champ électrique continu, alternatif ou pulsé de fréquence allant de 0Hz (champ continu) à 1000 kHz, que l'on utilise selon l'invention, peut être généré par tout système approprié de génération d'un champ électrique, qui est du type à couplage capacitif utilisant deux électrodes entre lesquelles le champ électrique est généré et qui fonctionne en courant continu, alternatif ou pulsé. Le courant alternatif ou pulsé utilisé pour générer le champ électrique alternatif ou pulsé a une fréquence au plus égale à 1000 kHz et de préférence allant de 10 Hz à 100 kHz.

Le polymère ou copolymère de styrène, qui forme au moins la partie superficielle de l'objet façonné à traiter selon l'invention et qui le plus souvent constitue la totalité de la matière dudit objet, peut être un homopolymère de styrène, un copolymère de styrène et d'un ou plusieurs comonomères insaturés tels que alphaméthylstyrène, acrylonitrile, anhydride maléique, pour lequel le styrène est en proportion pondérale majoritaire, un homopolymère ou un copolymère de styrène tel que précité, en particulier copolymère styrène/acrylonitrile, modifié par incorporation d'un élastomère, notamment polybutadiène ou copolymère éthylène/propylène, dans la masse dudit homopolymère ou copolymère de styrène au cours de sa synthèse, ou encore un copolymère séquencé de styrène et d'un diène conjugué tel que butadiène ou isoprène, à teneur pondérale majoritaire en styrène.

Le polymère ou copolymère de styrène utilisé pour fabriquer les objets façonnés, dont des exemples ont été donnés plus haut, peut encore renfermer des additifs tels que des charges, des colorants, des pigments, des agents de renforcement fibreux comme les fibres de verre, des antioxydants, des stabilisants thermiques.

L'invention est illustrée par les exemples suivants donnés à titre non limitatif.

### EXEMPLE 1:

A partir d'un polystyrène choc (additif choc=polybutadiène) exempt d'additif antistatique, on réalisait des plaques ayant une épaisseur de 3 mm en opérant par moulage par compression et on prélevait sur ces plaques des échantillons en forme de disques ayant un diamètre égal à 5 cm, puis soumettait lesdits échantillons à un traitement selon l'invention

Le traitement des échantillons était réalisé dans une enceinte de type capacitif dans laquelle étaient montées deux électrodes horizontales en forme de disques de 7 cm de diamètre et distants de 4 cm, ces électrodes étant connectées aux bornes d'un générateur de courant alternatif extérieur à l'enceinte, ledit générateur fournissant un courant électrique alternatif ayant une fréquence de 20 kHz avec une densité de puissance de 80 mW par cm² d'électrode. L'enceinte de traitement était pourvue, en outre, d'un conduit d'amenée du précurseur gazeux (composante organoétain) du flux gazeux réactif, débouchant à proximité de l'espace entre les électrodes, et était également connectée à l'aspiration d'une pompe primaire permettant de maintenir la pression désirée à l'intérieur de l'enceinte.

L'échantillon à traiter était placé entre les électrodes de l'enceinte de manière à reposer sur l'électrode inférieure et de ce fait ledit échantillon se trouvait directement dans la zone d'action du flux gazeux réactif résultant de l'action du champ électrique, prenant naissance entre les électrodes lorsque ces dernières sont mises sous tension, sur les vapeurs de la composante organoétain, à savoir tétraméthylétain dans cet exemple, injectées dans l'enceinte, à l'intérieur de laquelle la pression était maintenue à une valeur de 30 Pa par action de la pompe primaire. L'échantillon à traiter était à température ambiante.

Après une durée de traitement du disque échantillon par le flux gazeux réactif égale à 10 minutes, qui permettait de déposer un film transparent antistatique, dérivant du précurseur tétraméthylétain et présentant une épaisseur d'environ 450 nm, à la surface dudit disque échantillon, ce dernier était retiré de l'enceinte et laissé au contact de l'atmosphère ambiante.

Les disques échantillons, traités selon l'invention, étaient ensuite soumis à des mesures d'antistatisme après des durées variables.

Aux fins de comparaison, à partir d'un polystyrène choc antistatique commercial consistant en un polystyrène choc similaire à celui utilisé pour le traitement selon l'invention mais rendu antistatique par incorporation, dans sa masse, de 0,6 % en poids d'un additif antistatique du type amine éthoxylée, on préparait des disques témoins de mêmes dimensions que les disques traités selon l'invention, puis soumettait également les disques témoins à des mesures d'antistatisme comparables à celles effectuées sur les disques traités selon l'invention.

Dans son principe, la mesure d'antistatisme consiste à déposer, par décharge couronne, une quantité déterminée de charges en une zone de la surface du disque à étudier, puis à mesurer en fonction du temps, à l'aide d'une sonde électrostatique, la variation du potentiel de surface en cette zone.

Une décroissance lente du potentiel de surface traduit un mauvais comportement antistatique du substrat, tandis qu'une décroissance très rapide dudit potentiel est liée à un très bon comportement antistatique du substrat.

Le comportement antistatique d'un substrat peut être caractérisé par une grandeur appelée temps de demi-décharge (en abrégé t^{1/2}) et représentant le temps au bout duquel le potentiel de surface en un point du substrat est égal à la moitié du potentiel de surface initial après la charge. Les valeurs du temps de demi-décharge peuvent aller de zéro (cas d'un substrat conducteur) à l'infini (cas d'un substrat parfaitement isolant).

On donne dans le tableau I les valeurs (moyenne sur dix essais) du temps de demi-décharge déterminées pour les disques échantillons traités selon l'invention au bout de différentes durées D représentant le temps écoulé à partir de la date de traitement desdits échantillons.

Le tableau I renferme également, aux fins de comparaison, les valeurs (moyenne sur cinq essais) du temps de demi-décharge déterminées pour les disques témoins au bout de différentes durées D représentant le temps écoulé à partir de la fabrication desdits disques témoins.

**TABLEAU I**

| Echantillons | Selon l'invention | | | Témoins | | |
|---|---|---|---|---|---|---|
| D (jours) | 14 | 58 | 135 | 4 | 12 | 60 |
| t^{1/2} secondes | 65 | 45 | 45 | 58 | 66 | >200 |

L'examen des résultats figurant au tableau I fait ressortir que les échantillons traités selon l'invention pour les rendre antistatiques présentent un comportement antistatique substantiellement amélioré dans le temps par rapport aux échantillons témoins rendus antistatiques par la solution conventionnelle consistant à incorporer un additif antistatique dans la masse du polymère.

### EXEMPLE 2:

A partir d'un polystyrène choc exempt d'additif antistatique identique à celui utilisé dans l'exemple 1, on produisait des disques échantillons comme indiqué dans ledit exemple 1.

Les échantillons ainsi obtenus étaient traités en faisant appel au dispositif décrit dans l'exemple 1, l'échantillon étant encore placé entre les électrodes de l'enceinte de traitement de manière à reposer sur l'électrode inférieure.

Dans une première étape de traitement, après avoir fait le vide dans l'enceinte, on injectait dans ladite enceinte des vapeurs d'une composante organoétain consistant en tétraméthylétain et maintenait la pression dans cette enceinte à une valeur de 60 Pa par action de la pompe primaire.

Le générateur fournissant un courant alternatif ayant une fréquence de 20 kHz avec une densité de puissance de 90 mW par cm² d'électrode, on maintenait le disque échantillon pendant 15 minutes au contact du flux gazeux réactif résultant de l'action du champ électrique généré entre les électrodes sur les vapeurs de la composante organoétain, ce qui permettait de déposer un film transparent antistatique, dérivant du précurseur tétraméthylétain et présentant une épaisseur d'environ 650 nm, à la surface dudit disque échantillon.

A l'issue de cette première étape de traitement du disque échantillon, on soumettait cet échantillon, sans le déplacer, à une seconde étape de traitement consistant en un post-traitement plasma dans une atmosphère de vapeur d'eau. Pour ce faire, après avoir fait le vide dans l'enceinte pour éliminer le tétraméthylétain utilisé dans la première étape de traitement, on injectait de la vapeur d'eau dans ladite enceinte et maintenait cette enceinte sous une pression de vapeur d'eau égale à 5 Pa. Le générateur de courant fonctionnant sous une densité de puissance égale à 90 mW par cm² d'électrode, on maintenait le disque échantillon, revêtu du dépôt produit au cours de la première étape, pendant 10 minutes au contact du plasma résultant de l'action du champ électrique généré entre les électrodes sur la vapeur d'eau.

Au cours du traitement de la première étape aussi bien que du traitement de la seconde étape, le disque échantillon était à une température égale à la température ambiante.

A l'issue de la seconde étape de traitement, le disque échantillon était retiré de l'enceinte et laissé au contact de l'atmosphère ambiante.

Les disques échantillons, traités comme décrit dans le présent exemple, étaient ensuite soumis à des mesures d'antistatisme consistant à déterminer les valeurs (moyenne sur dix mesures) du temps de demi-décharge, comme indiqué dans l'exemple 1, au bout de différentes durées D représentant le temps écoulé à partir de la date de traitement desdits échantillons.

Les résultats obtenus sont rassemblés dans le tableau II.

**TABLEAU II**

| | | | | | |
|---|---|---|---|---|---|
| D (jours) | 0 | 10 | 145 | 210 | 315 |
| t^{1/2} (secondes) | 3 | 13 | 23 | 23 | 28 |

L'examen des résultats figurant au tableau II fait ressortir qu'en soumettant le dépôt plasma obtenu à partir du précurseur organoétain à un post-traitement dans un plasma de vapeur d'eau, on améliore le comportement antistatique initial (valeurs plus faibles du temps de demi-décharge) de l'échantillon post-traité par rapport à l'échantillon traité uniquement dans un plasma de la composante organoétain.

## Revendications

1. Procédé pour déposer un film mince antistatique et transparent à la surface d'un objet façonné, dont au moins la partie superficielle est en un polymère ou copolymère de styrène, et conférer ainsi audit objet un antistatisme durable sans modifier l'aspect de surface de cet objet, caractérisé en ce que l'on produit un flux gazeux réactif du type plasma froid en générant un champ électrique continu, alternatif ou pulsé ayant une fréquence allant de 0 Hz à 1 000 kHz, dans une atmosphère gazeuse maintenue sous une pression comprise entre 5 Pa et 100 Pa et constituée de vapeurs d'une composante organoétain formée d'un ou plusieurs composés organoétains ayant un point d'ébullition inférieur à 20° C sous pression de 150 Pa, la génération du champ électrique étant réalisée entre deux électrodes, entre lesquelles est placé l'objet façonné à traiter, et avec une densité de puissance comprise entre 50 mW et 350 mW par cm² d'électrode et l'on maintient ledit objet façonné, à une température inférieure à son point de ramollissement, au contact du flux gazeux réactif prenant naissance pendant une durée suffisante pour déposer à la surface dudit objet un film dérivant de la composante organoétain et dont l'épaisseur est comprise entre 10 nm et 1 500 nm.

2. Procédé selon la revendication 1, caractérisé en ce que le champ électrique généré pour produire le flux gazeux réactif à une fréquence allant de 0Hz à 100 kHz.

3. Procédé selon la revendication 1 ou 2, caractérisé en ce que l'atmosphère gazeuse constituée de vapeurs de la composante organoétain est maintenue sous une pression comprise entre 10 Pa et 70 Pa.

4. Procédé selon l'une des revendications 1 à 3, caractérisé en ce que l'objet façonné est maintenu à une température comprise entre 10° C et 60° C au contact du flux gazeux réactif.

5. Procédé selon l'une des revendications 1 à 4, caractérisé en ce que la durée du contact entre l'objet façonné et le flux gazeux réactif est choisie pour déposer un film dérivant de la composante organoétain ayant une épaisseur comprise entre 100 nm et 1 000 nm à la surface de l'objet façonné.

6. Procédé selon l'une des revendications 1 à 5, caractérisé en ce que l'atmosphère gazeuse à base de vapeurs de la composante organoétain, que l'on soumet à l'action du champ électrique pour produire le flux gazeux réactif, renferme une composante gazeuse oxygénée consistant en un ou plusieurs gaz oxygénés choisis parmi oxygène, vapeur d'eau et air, en quantité représentant au plus 10% en volume du mélange de la composante organoétain et de la composante oxygénée.

7. Procédé selon l'une des revendications 1 à 6, caractérisé en ce que, subséquemment à sa mise en contact avec le flux gazeux réactif produit à partir des vapeurs de la composante organoétain, l'objet façonné est soumis à un post-traitement consistant en une mise en contact, pendant une durée allant de 0,1s à 1 000s, avec un plasma froid généré à partir d'un gaz oxygéné consistant en oxygène ou/et vapeur d'eau, sous une pression de 1 Pa à 100 Pa et d'un champ électrique continu, alternatif ou pulsé.

8. Procédé selon l'une des revendications 1 à 7, caractérisé en ce que les composés organoétains, à partir desquels on forme la composante organoétain, répondent à la formule Sn (R) x (Cl)y, dans laquelle les R, identiques ou différents, représentent des radicaux alcoyles ou alcényles inférieurs, y est un nombre égal à 4-x et x est un nombre entier allant de 2 à 4, et possèdent un point d'ébullition inférieur à 20° C sous une pression de 150 Pa.

9. Procédé selon l'une des revendications 1 à 8, caractérisé en ce que le polymère ou copolymère de styrène, qui forme au moins la partie superficielle de l'objet façonné à traiter et qui le plus souvent constitue la totalité de la matière dudit objet, est un homopolymère de styrène, un copolymère de styrène et d'un ou plusieurs comonomères insaturés tels que alphaméthylstyrène, acrylonitrile, anhydride maléique, pour lequel le styrène est en proportion pondérale majoritaire, un homopolymère ou un copolymère de styrène tel que précité, en particulier copolymère styrène/acrylonitrile, modifié par incorporation d'un élastomère, notamment polybutadiène ou copolymère éthylène/propylène, dans la masse dudit homopolymère ou copolymère de styrène au cours de sa synthèse, ou encore un copolymère séquencé de styrène et d'un diène conjugué tel que butadiène ou isoprène, à teneur pondérale majoritaire en styrène.

## Patentansprüche

1. Verfahren zur Abscheidung eines dünnen antistatischen und transparenten Films auf der Oberfläche eines Formkörpers, wobei wenigstens der oberflächliche Anteil des Formkörpers aus einem Styrolpolymer oder -copolymer besteht, um auf diese Weise dem Körper dauerhafte antistatische Eigenschaften zu verleihen, ohne das Aussehen der Oberfläche dieses Körpers zu verändern, dadurch gekennzeichnet, daß man in einer Gasatmosphäre, die unter einem Druck zwischen 5 Pa und 100 Pa gehalten wird und aus Dämpfen einer Organozinnkomponente besteht, die aus einer oder mehreren Organozinnverbindungen mit einem Siedepunkt von unter 20°C unter einem Druck von 150 Pa gebildet wird, einen reaktiven Gasstrom von der Art eines kalten Plasmas erzeugt, indem man durch Gleich-, Wechsel- oder Mischstrom ein elektrisches Feld erzeugt, das eine Frequenz von 0 Hz bis 1000 kHz aufweist, wobei die Erzeugung des elektrischen Feldes zwischen zwei Elektroden, zwischen denen der zu behandelnde Formkörper angeordnet ist, und mit einer Leistungsdichte zwischen 50 mW und 350 mW pro cm² der Elektrode erfolgt, und man den Formkörper bei einer Temperatur unterhalb seines Erweichungspunktes mit dem entstehenden reaktiven Gasstrom während einer Zeitdauer kontaktiert, die ausreicht, um auf der Oberfläche des Körpers einen Film abzulegen, der aus der Organozinnkomponente gebildet ist und dessen Dicke zwischen 10 nm und 1500 nm liegt.

2. Verfahren nach Anspruch 1, dadurch gekennzeichnet, daß das zur Bildung des reaktiven Gasstroms erzeugte elektrische Feld eine Frequenz zwischen 0 Hz und 100 kHz aufweist.

3. Verfahren nach Anspruch 1 oder 2, dadurch gekennzeichnet, daß die aus Dämpfen der Organozinnkomponente zusammengesetzte Gasatmosphäre unter einem Druck zwischen 10 Pa und 70 Pa gehalten wird.

4. Verfahren nach einem der Ansprüche 1 bis 3, dadurch gekennzeichnet, daß der Formkörper bei einer Temperatur zwischen 10 und 60°C mit dem reaktiven Gasstrom in Berührung gebracht wird.

5. Verfahren nach einem der Ansprüche 1 bis 4, dadurch gekennzeichnet, daß die Dauer der Kontaktierung zwischen dem Formkörper und dem reaktiven Gasstrom so gewählt wird, daß ein Film, der aus der Organozinnkomponente gebildet ist, mit einer Dicke zwischen 100 nm und 1000 nm auf der Oberfläche des Formkörpers abgelegt werden kann.

6. Verfahren nach einem der Ansprüche 1 bis 5, dadurch gekennzeichnet, daß die Gasatmosphäre auf der Basis von Dämpfen der Organozinnkomponente, auf die man zur Erzeugung des reaktiven Gasstroms das elektrische Feld einwirken läßt, eine sauerstoffhaltige gasförmige Komponente, bestehend aus einem oder mehreren sauerstoffhaltigen Gasen, ausgewählt unter Sauerstoff, Wasserdampf und Luft, in einer Menge von höchstens 10%, bezogen auf das Volumen des Gemischs der Organozinnkomponente und der sauerstoffhaltigen Komponente, enthält .

7. Verfahren nach einem der Ansprüche 1 bis 6, dadurch gekennzeichnet, daß der Formkörper nach seiner Kontaktierung mit dem aus Dämpfen der Organozinnkomponente erzeugten reaktiven Gasstrom einer Nachbehandlung unterworfen wird, die in einer Kontaktierung während einer Zeitdauer von 0,1 s bis 1000 s mit einem aus einem sauerstoffhaltigen Gas, bestehend aus Sauerstoff und/oder Wasserdampf, unter einem Druck von 1 Pa bis 100 Pa und mit einem durch Gleich-, Wechsel- oder Mischstrom erzeugten elektrischen Feld erzeugten kalten Plasma besteht.

8. Verfahren nach einem der Ansprüche 1 bis 7, dadurch gekennzeichnet, daß die Organozinnverbindungen, aus denen man die Organozinnkomponente bildet, der Formel Sn(R)ₓ(Cl)_{y}, in der R gleiche oder unterschiedliche Bedeutung hat und einen Niederalkyl- oder Niederalkenylrest darstellt, y eine Zahl 4-x und x eine ganze Zahl von 2 bis 4 bedeuten, entspricht und einen Siedepunkt unter einem Druck von 150 Pa von unter 20°C besitzen.

9. Verfahren nach einem der Ansprüche 1 bis 8, dadurch gekennzeichnet, daß das Styrolpolymer oder -copolymer, das wenigstens den oberflächlichen Anteil des zu behandelnden Formkörpers bildet und meist die Gesamtheit des Stoffes des Körpers ausmacht, ein Styrolhomopolymer, ein Copolymer aus Styrol und einem oder mehreren ungesättigten Comonomeren wie α-Methylstyrol, Acrylnitril, Maleinsäureanhydrid, wobei der Hauptanteil des Gewichts auf Styrol entfällt, ein Styrolhomopolymer oder -copolymer, wie oben angegeben, insbesondere ein Styrol-Acrylnitril-Copolymer, das durch Einarbeitung eine Elastomers, insbesondere von Polybutadien oder Ethylen-Propylen-Copolymer in die Masse des Styrolhomopolymers oder -copolymers im Verlaufe seiner Synthese modifiziert wurde, oder ein Blockcopolymer aus Styrol und einem konjugierten Dien wie Butadien oder Isopren, wobei der Hauptanteil des Gewichts auf Styrol entfällt, ist.

## Claims

1. Method of depositing a thin antistatic and transparent film on the surface of a shaped object of which at least the surface portion is made of a styrene polymer or copolymer and thus conferring on the said object a durable antistatic effect without modifying the surface appearance of this object, characterized in that a reactive gaseous flux of the cold plasma type is produced by the generation of a direct-current, alternating or pulsed electric field having a frequency of from 0 Hz to 1,000 kHz in a gaseous atmosphere kept under a pressure of between 5 Pa and 100 Pa and constituted by vapours of an organotin component formed of one or a plurality of organotin compounds having a boiling point below 20°C under a pressure of 150 Pa, the electric field being generated between two electrodes between which the shaped object to be treated is placed, and with a power density of between 50 mW and 350 mW per cm² of electrode, the said shaped object being kept, at a temperature below its softening point, in contact with the reactive gaseous flux arising, for a period long enough for a film derived from the organotin component and having a thickness of between 10 nm and 1,500 nm to be deposited on the surface of the said object.

2. Method according to Claim 1, characterized in that the electric field generated in order to produce the reactive gaseous flux has a frequency of from 0 Hz to 100 kHz.

3. Method according to Claim 1 or Claim 2, characterized in that the gaseous atmosphere constituted by vapours of the organotin component is kept under a pressure of between 10 Pa and 70 Pa.

4. Method according to any one of Claims 1 to 3, characterized in that the shaped object is kept, at a temperature of between 10°C and 60°C, in contact with the reactive gaseous flux.

5. Method according to any one of Claims 1 to 4, characterized in that the duration of the contact between the shaped object and the reactive gaseous flux is selected so that a film derived from the organotin component and having a thickness of between 100 nm and 1,000 nm is deposited on the surface of the shaped object.

6. Method according to any one of Claims 1 to 5, characterized in that the gaseous atmosphere based on vapours of the organotin component which is subjected to the action of the electric field in order to produce the reactive gaseous flux includes an oxygenated gaseous component consisting of one or a plurality of oxygenated gases selected from oxygen, water vapour and air, in a quantity representing at most 10% by volume of the mixture of the organotin component and the oxygenated component.

7. Method according to any one of Claims 1 to 6, characterized in that, after it has been put in contact with the reactive gaseous flux produced from vapours of the organotin component, the shaped object is subjected to an after-treatment consisting of its being put in contact for a period of from 0.1 s to 1,000 s with a cold plasma generated from an oxygenated gas consisting of oxygen and/or water vapour under a pressure of from 1 Pa to 100 Pa and from a direct-current, alternating or pulsed electric field.

8. Method according to any one of Claims 1 to 7, characterized in that the organotin compounds from which the organotin component is formed correspond to the formula Sn(R)x (Cl)y, in which the "R"s, which are identical of different, represent lower alkyl or alkenyl radicals, y is a number equal to 4-x and x is a whole number from 2 to 4, and have a boiling point lower than 20°C under a pressure of 150 Pa.

9. Method according to any one of Claims 1 to 8, characterized in that the styrene polymer or copolymer which forms at least the surface portion of the shaped object to be treated and which usually constitutes all of the material of the said object is a styrene homopolymer, a copolymer of styrene with one or a plurality of unsaturated comonomers such as alpha-methylstyrene, acrylonitrile, maleic anhydride, for which the styrene is in a larger proportion by weight, a styrene hompolymer or copolymer as mentioned above, particularly styrene/acrylonitrile copolymer modified by the incorporation of an elastomer, particularly polybutadiene or ethylene/propylene copolymer, in the mass of the said styrene homopolymer or copolymer during its synthesis, or a sequenced copolymer of styrene and a conjugated diene such as butadiene or isoprene with a larger content by weight of styrene.
